# EUROPEAN PATENT SPECIFICATION

(11) **EP 1 542 236 B1**
(45) Date of publication and mention of the grant of the patent: **24.09.2008**
(21) Application number: 04257268.5
(22) Date of filing: 24.11.2004
(51) Int. Cl.: G11C 11/16, G11C 29/00

(54) **Apparatus and method of analyzing magnetic random access memory**
Anordnung und Verfahren zur Analyse eines magnetischen Direktzugriffspeichers
Dispositif et méthode d'analyse d'une mémoire magnétique à accès aléatoire

(30) Priority: 24.11.2003 KR 2003083614
(43) Date of publication of application: 15.06.2005
(73) Proprietor: SAMSUNG ELECTRONICS CO., LTD., Suwon-city, Gyeonggi-do (KR)
(72) Inventor: Park, Wan-jun, Gangnam-gu, Seoul (KR); Hwang, In-Jun, c/o Samsung Adv. Inst. of Techn., Yongin-si, Gyeonggi-do (KR); Kim, Tae-wan, Yongin-si, Gyeonggi-do (KR)
(74) Representative: Greene, Simon Kenneth

(56) References cited:
- WO-A-03/036734
- US-A1- 2001 019 461
- US-B1- 6 275 411
- US-B1- 6 538 940

## Description

The present invention relates to an apparatus and method of analyzing a magnetic random access memory (MRAM), and more particularly, to an apparatus and method of analyzing an MRAM, which is capable of analyzing all characteristics of the MRAM within a fast time.

Magnetic Random Access Memory (MRAM), one of nonvolatile memories, is a solid-state magnetic memory that uses magnetoresistance effect based on nano magnetic material's characteristic effect of spin dependent tunneling. The MRAM uses a giant magnetoresistance effect or tunnel magnetoresistance effect that occurs because spin of electron (degree of freedom of electron) influences greatly on electron transfer. A conventional MRAM includes a cell array. Word lines extend along rows of memory cells and bit lines extend along columns of memory cells. That is, the memory cells are located at intersections of the word lines and the bit lines. Each memory cell includes two magnetic layers, which are a fixed layer and a free layer. The fixed layer is magnetically fixed and the free layer has a variable magnetization direction. The memory cell stores data bit according to a relative magnetization orientation of the fixed layer and the free layer.

There is a limitation on selection of a material for a memory because low power consumption is required for commercializing the memory. The conventional MRAM uses permalloy (NiFe) in a switching field, that is, the free layer of magnetoresistance element in order to reduce power consumption. Increase of magnetoresistance is essential for increase of the MRAM's operating speed and efficient design of chip architecture. To achieve this, a magnetic thin layer used in the free layer must have a ferromagnetic characteristic and a high polarization characteristic.

The MRAM having the above structure, for example a tunnel magnetoresistance (TMR) structure, distinguishes data "0" and "1" by measuring variation of tunnel resistances according to magnetic states of the two ferromagnetic layers, which are separated by tunnel barrier. There are various non-uniform states during switching of the magnetic states of the ferromagnetic layers (free layers), i.e. writing data on the memory. The non-uniform states cause erroneous operation of the memory.

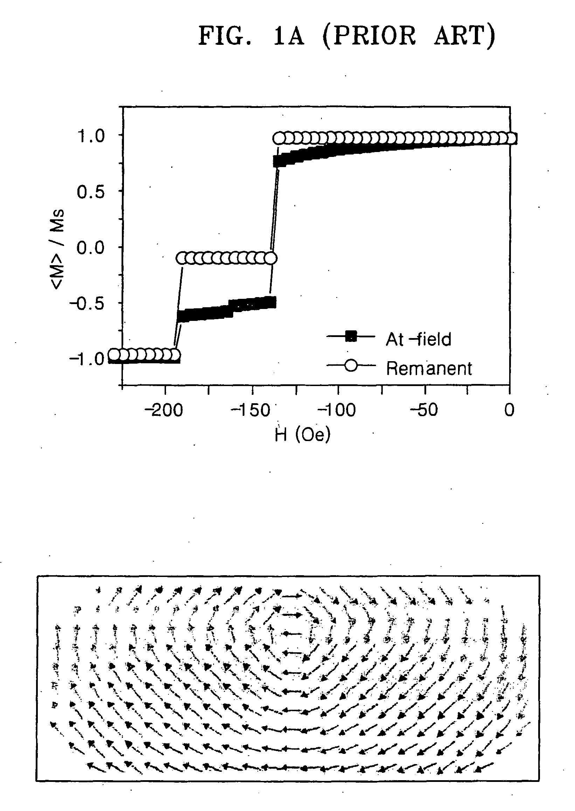

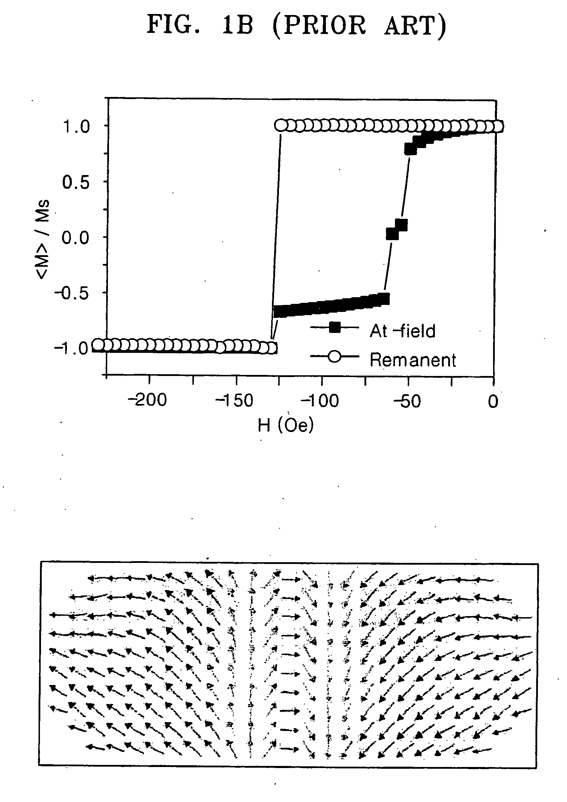

Generally, there are two factors that cause the non-uniform switching states of the memory. FIGS. 1A and 1B show the non-uniform switching states. FIG. 1A shows magnetic characteristics of spins of the free layer within domain against an applied magnetic field when the spins are arrayed in a vortex structure. The free layer is made of ferromagnetic material and provided in the MRAM structure. FIG. 1B shows magnetic characteristics of the spins of the free layer within domain when the spins are in a fixed state at some portion. In such a structure, the MRAM shows the non-uniform switching states.

To find out the non-uniform switching states, a measurement device that systematically measures characteristics of the MRAM is necessary. A conventional method of measuring the switching characteristics of the MRAM is accomplished by measuring resistance of a unit cell under magnetic field in every unit cell. In this case, it takes a lot of time to measure all properties of an MRAM array at a wafer level because it takes time for the magnetic field to be stabilized. There have been introduced a method of synchronizing a resistance measurement with the magnetic field in order to improve measurement speed. However, this method cannot measure remanence and thus the cause of the non-uniform switching process in the MRAM cannot be searched out.

WO 03/036734 describes a magnetoresistive memory element. A graph of total magnetoresistance against applied magnetic field is presented.

According to an aspect of the present invention, there is provided an analysis apparatus of MRAM, according to claim 1.

The magnetic field applying unit may include: a power supply unit which supplies power; and a magnetic field generator which generates magnetic field applied to the MRAM that is mounted on the MRAM mounting unit.

The present invention provides an apparatus and method of analyzing an MRAM, which is capable of measuring a switching characteristic of an MRAM array at a wafer level at a fast speed.

The magnetic field generator may be a Helmholtz coil which is formed in a shape of a turned circular coil.

The cell addressing unit comprises: a matrix switch which designates the unit cell of the MRAM mounted on the MRAM mounting unit; and a probe card that is mounted on a position corresponding to the MRAM, the probe card supplying power to the unit cell or reading out data of the unit cell.

The analysis apparatus may further comprise a magnetic-field measuring unit, which measures the external magnetic field that is applied to the MRAM by the magnetic field applying unit.

According to another aspect of the present invention, there is provided a use of the above apparatus as set out in claim 6. The method comprises: (a) applying a magnetic field to an MRAM cell array; (b) selecting a target unit cell among the MRAM cell array; (c) measuring a resistance of the selected unit cell and storing the measured resistance; (d) varying a strength of the magnetic field applied to the selected unit cell and measuring resistances of the selected unit cell according to the varied strength of the magnetic field; and (e) executing the processes (b) through (d) for whole unit cells which constitute the MRAM cell array.

The magnetic field may be applied by a Helmholtz coil which is formed in a shape of a turned circular coil.

The target unit cell may be selected using a previously inputted address information of the MRAM cell array by a cell addressing unit.

The resistance of the selected unit cell may be measured using data that is obtained by a probe of a probe card, the probe card being positioned at a data storage portion of the selected unit cell.

Also, according to the present invention, there is provided an analysis method of MRAM, which comprises: (a) applying a magnetic field to an MRAM cell array; (b) selecting a target unit cell among the MRAM cell array; (c) measuring a resistance of the selected unit cell and storing the measured resistance; (d) executing the processes (b) and (c) for the remaining unit cells that constitute the MRAM cell array; and (e) varying a strength of the magnetic field and executing the processes (a) through (d) for all unit cells of the MRAM cell array.

Further, according to the present invention, there is provided an analysis method of MRAM, which comprises: (a) selecting a target unit cell among an MRAM cell array; (b) applying a magnetic field to the selected unit cell; (c) measuring a resistance of the selected unit cell and storing the measured resistance; (d) varying a strength of the magnetic field applied to the selected unit cell and measuring resistances of the selected unit cell according to the varied strength of the magnetic field; and (e) executing the processes (a) through (d) for whole unit cells that constitute the MRAM cell array.

In the applying of the magnetic field, a source measurement unit applies an electric potential to the selected unit cell, thereby forming an internal magnetic field.

Furthermore, according to the present invention, there is provided an analysis method of MRAM, which comprises: (a) selecting a target unit cell among an MRAM cell array; (b) applying a magnetic field to the selected unit cell; (c) measuring a resistance of the selected unit cell and storing the measured resistance; (d) executing the processes (a) through (c) for the remaining unit cells that constitute the MRAM cell array; and (e) varying a strength of the magnetic field and executing the processes (a) through (d) for all unit cells of the MRAM cell array.

The above and other features and advantages of the present invention will become more apparent by describing in detail exemplary embodiments thereof with reference to the attached drawings in which:
FIGS. 1A and 1B are graphs showing non-uniform switching states of MRAM;
FIG. 2A is a view illustrating an analysis apparatus of MRAM according to an embodiment of the present invention;
FIG. 2B is a view illustrating magnetic field that is applied to a target MRAM by the magnetic-field applying unit of FIG. 2A;
FIG. 2C is a view illustrating a cell addressing unit that analyzes a target MRAM in the analysis apparatus of the MRAM according to the present invention;
FIG. 3A is a view illustrating an analysis method of MRAM according to an embodiment of the present invention;
FIG. 3B is a view of an MRAM cell array;
FIGS. 4A and 4B are hysteresis graphs illustrating magnetic characteristics of MRAM with respect to electric potential when an external magnetic field is applied by a magnetic-field applying unit;
FIGS. 4C and 4D are hysteresis graphs illustrating residual induction of MRAM with respect to electric potential when an external magnetic field is applied by a magnetic-field applying unit;
FIGS. 5A and 5B are hysteresis graphs illustrating magnetic characteristic of MRAM with respect to electric potential when an internal magnetic field is applied by a source measurement unit; and
FIGS. 6A and 6B are asrteroid curves that are plotted by combination of measured hysteresis graphs after applying external and internal magnetic fields to a MRAM cell array in the analysis method of the MRAM according to the present invention.

The present invention will now be described more fully with reference to the accompanying drawings, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art. In the drawings, the thickness of layers and regions are exaggerated for clarity. Like reference numerals in the drawings denote like elements, and thus their description will be omitted.

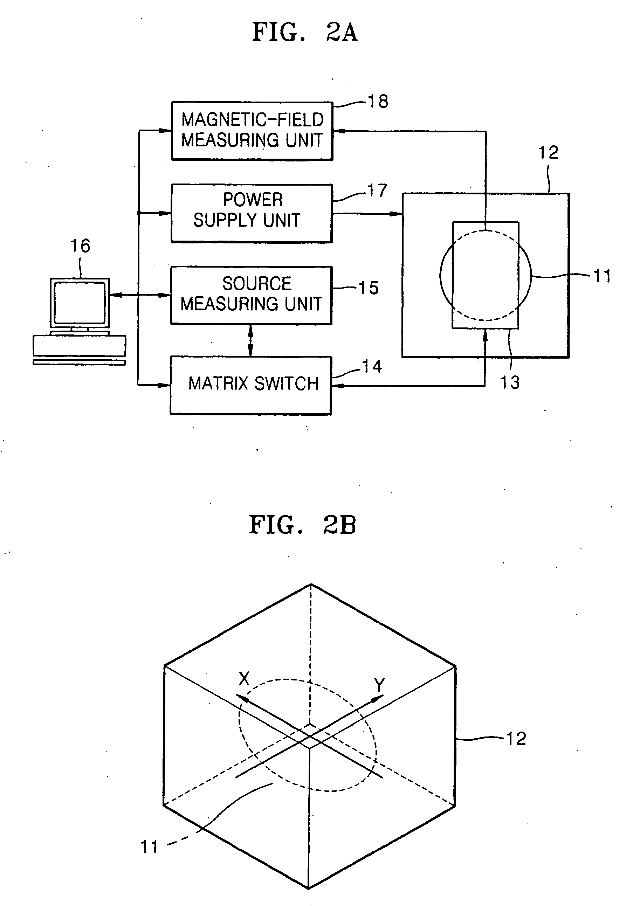

FIG. 2A illustrates an analysis apparatus of MRAM according to an embodiment of the present invention. The analysis apparatus according to the present invention includes an MRAM mounting unit 11 on which an MRAM is mounted, a magnetic-field applying unit 12 and 17 which applies magnetic field around the MRAM mounting unit 11, a cell addressing unit 13 and 14 which selects a certain cell of the target MRAM, which intends to be analyzed, and obtains necessary data, a source measurement unit 15 which measures a resistance of the selected cell of the MRAM, and a computer unit 16 which collects, analyze and stores information on the resistance of each selected cell of the MRAM. Further, the analysis apparatus may further include a magnetic-field measuring unit 18 which gauges magnetic field strength applied to the MRAM during an analysis procedure.

FIG. 2B is a view schematically illustrating a structure of the MRAM mounting unit 11, which is disposed within the magnetic field generator 12 of the magnetic-field applying unit.

Referring to FIG. 2B, the magnetic field generator 12 surrounds the MRAM mounting unit 11 in order to apply a uniform magnetic field to the MRAM, which is mounted on the MRAM mounting unit 11. The MRAM that is mounted on the MRAM mounting unit 11 has an ordinary array structure. That is, the MRAM has an integrated structure of wafer-level unit cells, in which a plurality of unit cells (for example, m x n unit cells) are arrayed in a matrix form.

As described above, the magnetic-field applying unit includes a power supply unit 17 and the magnetic field generator 12. The power supply unit 17 supplies power for generating magnetic field and the magnetic field generator 12 generates magnetic field with the supplied power. The magnetic field generator 12 is designed to apply the uniform magnetic field to the MRAM mounted on the MRAM mounting unit 11 in both x and y directions. The magnetic field generator 12 may use a Helmholtz coil which is made of a typically turned coil.

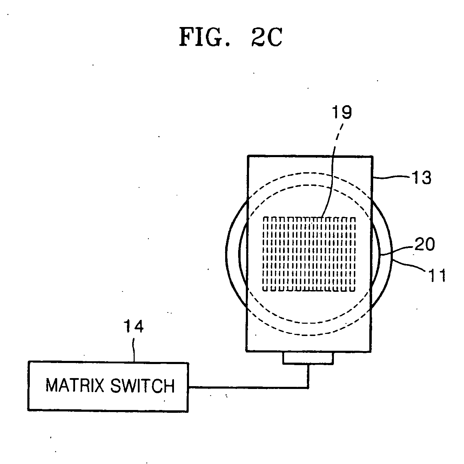

FIG. 2C illustrates the cell addressing unit that is loaded on a wafer-level MRAM cell array 20 in the analysis apparatus according to the present invention. The cell addressing unit includes a probe card 13 and a matrix switch 14. The matrix switch 14 selects the specific unit cell 19 to be analyzed in the MRAM cell array 20. The probe card 13 may be an ordinary probe card that inspects semiconductor devices. Probes of the probe card 13 are in contact with each unit cell 19 which constitutes the MRAM cell array 20. The specific unit cell 19 of the MRAM cell array 20 is designated and selected by the matrix switch 14.

The source measurement unit 15 will now be described with reference to FIGS. 2A and 2C. The source measurement unit (SMU) 15 applies an internal magnetic field to the MRAM cell array 20 mounted on the MRAM mounting unit 11. Further, the source measurement unit 15 functions to acquire data (resistance) of the specific unit cell 19. The source measurement unit 15 can be a typical measurement unit that is widely used in the related art. The source measurement unit 15 applies an electric potential to the specific unit cell 19 that is selected by the matrix switch 14, such that the internal magnetic field is formed only at the specific unit cell 19. Further, the source measurement unit 15 can measure the resistance of the certain unit cell 19 using an electric signal on the probe card 13. Since the function of the above-described source measurement unit 15 is well known in the general device analysis, its detail description will be omitted.

The computer unit 16 stores data, such as the resistances of the MRAM, which are acquired by the source measurement unit 15. The computer unit 16 also analyzes characteristics of the MRAM. Furthermore, the computer unit 16 functions to transmit an address of the target unit cell to the matrix switch 14. This means that the computer unit 16 provides data so that the matrix switch 14 can select the specific unit cell 19 using data that is previously given in a process of designing the MRAM cell array.

The analysis apparatus according to the present invention may further include the magnetic-field measuring unit 18 which gauges magnetic field strength applied to the MRAM cell array 20, in which the MRAM cell array 20 is mounted on the MRAM mounting unit 11 within the magnetic field generator 12.

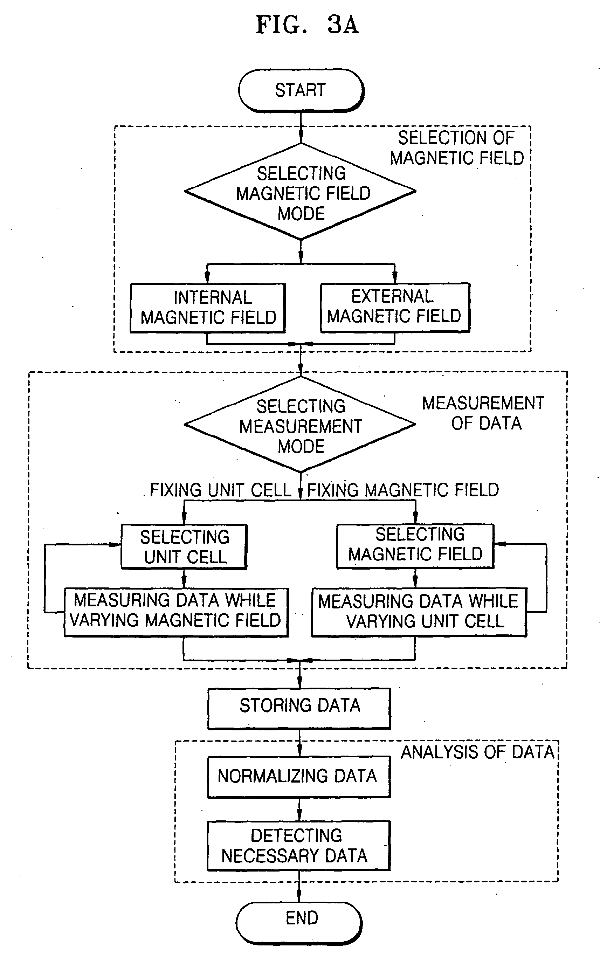

An analysis method of MRAM according to the present invention will now be described in detail. FIG. 3A shows the analysis method of MRAM according to an embodiment of the present invention. The analysis method according to the present invention is to analyze resistances of unit cells of MRAM when uniform magnetic field is applied to a MRAM cell array 20 or a specific unit cell of the MRAM.

The analysis method according to the present invention includes selecting a magnetic field mode, measuring data according to a selection of a measurement mode, and analyzing data. The operation of the analysis method will be described below.

In the selecting of the magnetic field mode, it is determined whether to apply an external magnetic field or an internal magnetic field to the MRAM cell array 20 or the specific unit cell 19 of the MRAM. If the external magnetic field is applied, the magnetic field generator 12 applies the uniform magnetic field to the whole MRAM cell array 20. If the internal magnetic field is applied, the source measurement unit 15 applies an electric potential to the specific unit cell 19 through the probe card 13 such that magnetic field is formed only at the specific unit cell 19 of the MRAM.

In case where characteristics of the MRAM cell array 20 are analyzed under the external magnetic field, there is an advantage of a fast analysis time. On the other hand, in case where characteristics of the MRAM cell array 20 are analyzed at every unit cell under the internal magnetic field, there is a disadvantage in that it takes long time to analyze the characteristics of the whole MRAM cell array 20, but there is an advantage in that the analysis is performed at a circumstance similar to an actual operation of the MRAM cell array 20. The present invention provides the analysis method of MRAM, which is adoptable to both the cases. Further, the analysis method of the present invention can be used to analyze the unit cell of MRAM, the MRAM cell array, and the wafer-level MRAM.

The target MRAM that intends to be analyzed is mounted on the MRAM mounting unit 11. It is possible to inspect a process-finished MRAM as well as a wafer that has MRAM integrated during a fabricating process.

After mounting the MRAM, a specific unit cell 19 of the whole unit cells is designated. Herein, a location of the specific unit cell 19 that is designated by the matrix switch 14 is searched using MRAM's address information stored in the computer unit 16. The probe card 13 is in contact with a location corresponding to the address of the specific unit cell 19.

The uniform magnetic field is applied to the mounted MRAM. Herein, in case where the external magnetic field is applied, if the power supply unit 17 applies ' electric potentials I₁ and I₂ to the magnetic field generator 12, magnetic fields Hₓ and H_{y} are formed at the magnetic field generator 12. As shown in FIG. 2B, the uniform magnetic field is applied to the whole MRAM. The magnetic field that is applied around to the MRAM can be measured accurately by the magnetic-field measuring unit 18.

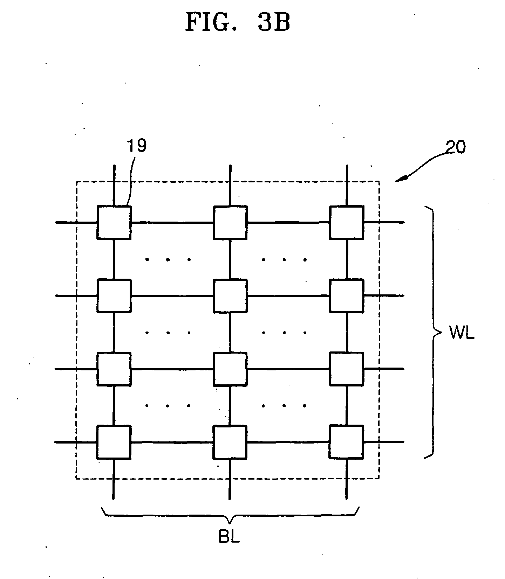

In case where the internal magnetic field is applied by the source measurement unit 15, the cell addressing unit 13 and 14 designates the specific unit cell 19 and the source measurement unit 15 applies the electric potentials I₁ and I₂. As shown in FIG. 3B, the electric potentials are applied only to the specific unit cell 19 through a word line and a bit line, thereby generating the internal magnetic field only at the specific unit cell 19. The magnetic field mode can use both the directly applied magnetic field and a residual magnetic field, which remains after the magnetic field is applied for a certain time.

Next, the measuring of data according to a selection of a measurement mode will be described in detail. Herein, desired data, e.g., the resistance of MRAM, are measured in a state that the external or internal magnetic field is applied. That is, the data is read out from the specific unit cell 19, which is designated by the cell addressing unit 13 and 14 of the analysis apparatus according to the present invention.

Two modes may be selected. In a first method, the resistance of the specific unit cell 19 of the MRAM cell array 20 is measured in a state that the magnetic field is applied to the specific unit cell 19 of the MRAM cell array 20, and then, the resistance of each unit cell 19 of the whole MRAM cell array 20 is measured under the same magnetic field strength. Then, the resistance of each unit cell 19 is measured while the magnetic field strength is varied. In short, the resistance of each unit cell 19 is measured under a fixed strength of the magnetic field, and then, the characteristics of the MRAM are analyzed under the varying strength of magnetic field.

In a second method, the specific unit cell 19 of the MRAM is selected. A predetermined strength of the magnetic field is applied to the selected unit cell 19 and the resistance of the selected unit cell 19 is measured. Then, a resistance of the selected unit cell 19 is measured in a state that the magnetic field strength is varied. In other word, the resistances of the unit cell 19 are measured while varying the strength of the magnetic field that is applied in a state that the unit cell is fixed. After measuring all resistances of one unit cell 19 corresponding to all measurement range of the magnetic field strength, resistances of another unit cell corresponding to the measurement ranges of the magnetic field strength are measured. In this manner, the other unit cells are measured.

In the selection of the specific unit cell 19, the matrix switch 14 of the cell addressing unit 13 and 14 designates a measuring order of the unit cells 19 of the MRAM cell array 20 using the address information of the MRAM cell array 20, which is previously stored in the computer unit 16. The probe of the probe card 13 continuously detects data of the unit cells 19 of the MRAM cell array 20 in the designated order. The source measurement unit 15 reads out the resistances of the unit cells 19 and the computer unit 16 stores the read-out resistances.

The source measurement unit 15 reads out the resistance using a current that flows through the probe of the probe card 13 which is in contact with each unit cell 19, for example, a current that is extracted from data storage area of a magnetic tunnel junction (MTJ) structure, and then, the resistances are stored in the computer unit 16. The measuring of data according to the selection of the measurement mode can be applied to both the external magnetic field and the internal magnetic field.

A case of applying a predetermined external magnetic field to the MRAM cell array 20 will now be described. The matrix switch 14 selects the specific unit cell 19 and the source measurement unit 15 applies a source voltage to the selected unit cell 19 through the probe card 13. The source measurement unit 15 reads out the resistance using the current that is extracted from the selected certain unit cell 19, and the read-out resistance is stored in the computer unit 16.

A method of measuring data while varying magnetic field strength (in a state that the unit cell is fixed) will now be described. The power supply unit 17 varies power so that the magnetic field generator 12 generates different magnetic fields. Through the repetition of the above process, resistances of the selected unit cell 19 is measured over a certain range of magnetic field strength. Such processes are repeated for the each unit cell 19 of the MRAM cell array 20.

A method of measuring data while selectively varying the unit cells (in a state that the magnetic field is fixed) will now be described. A resistance of the selected unit cell 19 is measured under a predetermined external magnetic field strength. After resistances of the unit cells are measured while varying the unit cells under the same strength of the external magnetic field. Then, resistances of the unit cells are measured while varying the external magnetic field strength. All the measured resistances of the unit cells 19 are stored.

As describe above, the resistances of the unit cells 19 of the MRAM cell array 20 are measured and stored in the computer unit 16. Various analysis data about all unit cells 19 of the MRAM cell array 20 can be obtained through combination of the data regarding the measured characteristic resistances. For example, it is possible to obtain hysteresis loop, which represents variation of resistance with respect to the applied magnetic field. Of course, hysteresis loop for the whole MRAM can also be obtained through its combinations. A switching field can be found by differentiating the hysteresis loop and an asrteroid curve can be plotted. The computer unit 16 analyses the given data to obtain the analysis data. Since theories, such as equations used for the analysis, are well known, their detail description will be omitted.

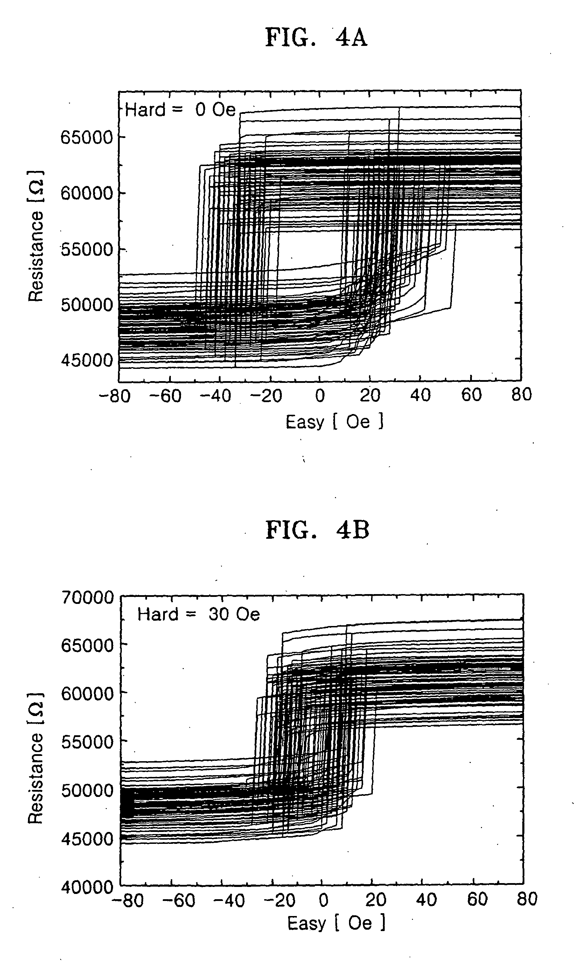

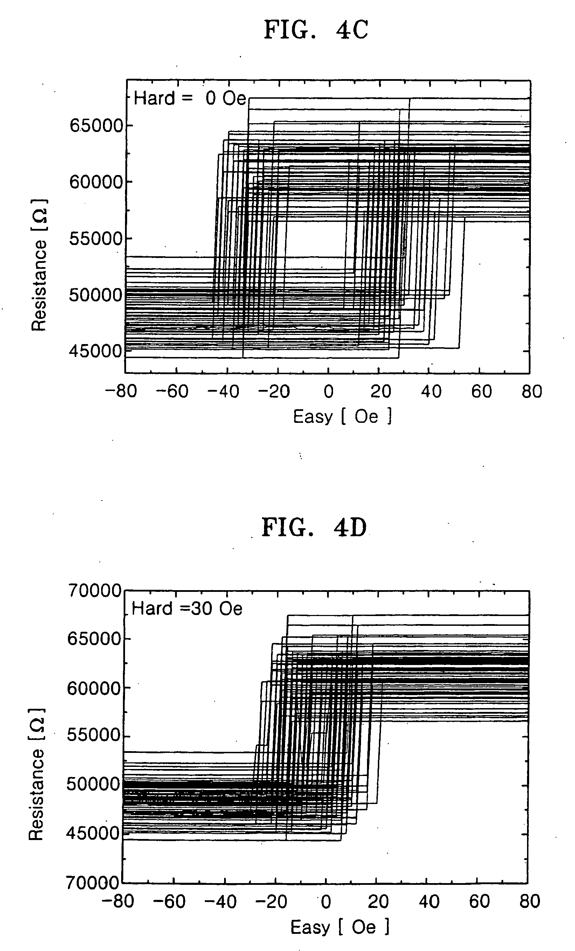

FIGS. 4A and 4B are hysteresis graphs illustrating magnetic characteristics of the MRAM cell array 20 with respect to the strength of the external magnetic field applied by the magnetic field generator 12 according to the present invention. FIGS. 4C and 4D are hysteresis graphs illustrating residual induction of the MRAM with respect to the external magnetic field applied by the magnetic field generator 12 according to the present invention. In the drawings, there are shown all hysteresis loops of all the unit cells 19 of the MRAM cell array 20 in one graph.

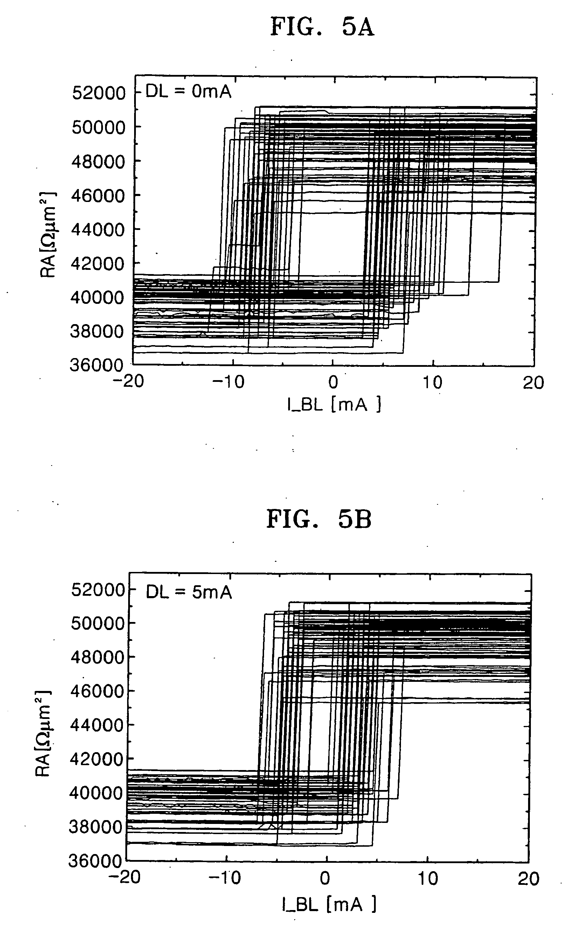

FIGS. 5A and 5B are hysteresis graphs illustrating magnetic characteristics of the MRAM with respect to the internal magnetic field that is applied by the source measurement unit 15 according to the present invention.

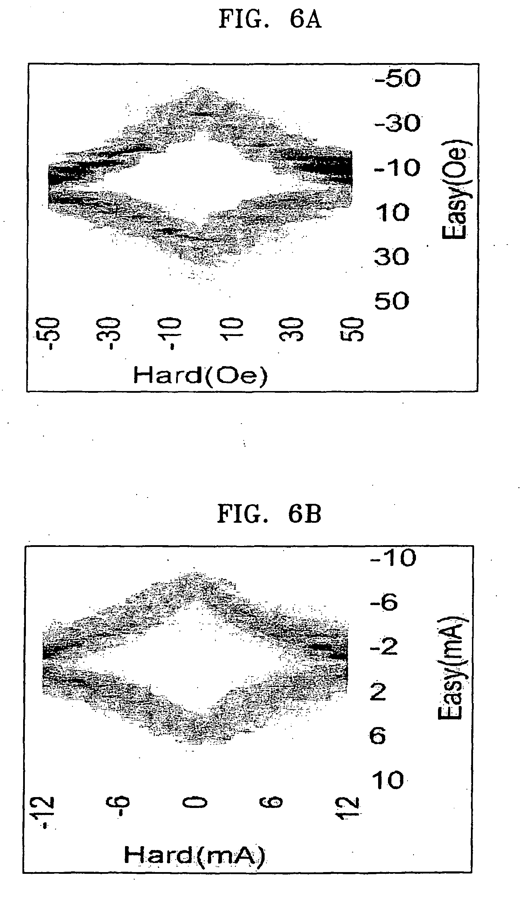

FIGS. 6A and 6B are asrteroid curves that are plotted out of hysteresis loops which are measured after applying the external and internal magnetic fields to the MRAM cell array 20 according to the analysis method of the present invention. By selecting values that are located outside the lozenge-shaped asrteroid curve, the switching fields of the whole MRAM cell array 20 are easily extracted to drive the MRAM cell array 20.

According to the present invention, characteristics of the whole MRAM having the MRAM cell array consisting of a plurality of unit cells or an integrated structure of wafer-level unit cells can be measured at a fast speed with a relatively simple structure.

Further, the present invention can analyze the characteristics and defect rate of the MRAM at early stage of the manufacturing process, thereby increasing yield of the high quality MRAM.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. An analysis apparatus of a magnetic random access memory, short MRAM, comprising:
an MRAM mounting unit (11) on which an MRAM is mounted;
a magnetic-field applying unit (12, 17) which is positioned around the MRAM mounting unit and applies an external magnetic field to the MRAM mounted on the MRAM mounting unit;
a cell addressing unit (13, 14) which designates a unit cell of the MRAM mounted on the MRAM mounting unit;
a source measurement unit (15) which applies an internal magnetic field to the unit cell of the MRAM or measures a resistance of the unit cell of the MRAM; and
a computer unit (16) which stores and analyzes data regarding the measured resistance of the each unit cell of the MRAM.

2. The analysis apparatus of claim 1, wherein the magnetic field applying unit (12, 17) comprises:
a power supply unit (17) which supplies power; and
a magnetic field generator (12) which generates magnetic field applied to the MRAM that is mounted on the MRAM mounting unit.

3. The analysis apparatus of claim 2, wherein the magnetic field generator (12) is a helmholtz coil which is formed in a shape of a turned circular coil.

4. The analysis apparatus of any preceding claim, wherein the cell addressing unit (13, 14) comprises:
a matrix switch (14) which designates the unit cell of the MRAM mounted on the MRAM mounting unit; and
a probe card (13) that is mounted on a position corresponding to the MRAM, the probe card supplying power to the unit cell or reading out data of the unit cell.

5. The analysis apparatus of any preceding claim, further comprising a magnetic-field measuring unit (18), which measures the external magnetic field that is applied to the MRAM by the magnetic field applying unit.

6. Use of an analysis apparatus according to any of claims 1 to 5 to carry out an analysis method of MRAM, comprising:
(a) applying a magnetic field to an MRAM cell array (20);
(b) selecting a target unit cell (19) among the MRAM cell array;
(c) measuring a resistance of the selected unit cell (19) and storing the measured resistance;
and repeating steps (b) and (c) and varying a strength of the magnetic field to measure the resistances of the unit cells according to the varied strength of the magnetic field.

7. The use of claim 6, comprising:
(d) varying a strength of the magnetic field applied to the selected unit cell (19) and measuring resistances of the selected unit cell according to the varied strength of the magnetic field; and
(e) executing the processes (b) through (d) for whole unit cells (19) which constitute the MRAM cell array.

8. The use of claim 6, comprising:
(d) after measuring the resistance of the selected unit cell, executing the processes (b) and (c) for the remaining unit cells (19) that constitute the MRAM cell array (20); and
(e) varying a strength of the magnetic field and executing the processes (a) through (d) for all unit cells of the MRAM cell array.

9. The use of claim 7 or 8, wherein the magnetic field is applied by a helmholtz coil (12) which is formed in a shape of a turned circular coil.

10. The use of claims 7, 8, or 9, wherein the target unit cell (19) is selected using a previously inputted address information of the MRAM cell array by a cell addressing unit.

11. The use of claims 7, 8, 9 or 10, wherein the resistance of the selected unit cell (19) is measured using data that is obtained by a probe of a probe card (13), the probe card (13) being positioned at a data storage portion of the selected unit cell.

12. The use of claim 6, comprising:
(d) after measuring the resistance of the selected unit cell (19) varying a strength of the magnetic field applied to the selected unit cell and measuring resistances of the selected unit cell according to the varied strength of the magnetic field; and
(e) executing the processes (a) through (d) for whole unit cells that constitute the MRAM cell array.

13. The use of claim 12, wherein the target unit cell (19) is selected using a previously inputted address information of the MRAM cell array by a cell addressing unit (13,14).

14. The use of claim 12 or 13, wherein in the applying of the magnetic field, a source measurement unit (15) applies an electric potential to the selected unit cell, thereby forming an internal magnetic field.

15. The use of MRAM of claims 12, 13 or 14, wherein the resistance of the selected unit cell (19) is measured using data that is obtained by a probe of a probe card (13), the probe card being positioned at a data storage portion of the selected unit cell.

16. The use of claim 6, comprising:
(c) measuring the resistance of the selected unit cell (19) and storing the measured resistance;
(d) after executing the processes (a) through (c) for the remaining unit cells that constitute the MRAM cell array (20); and
(e) varying a strength of the magnetic field and executing the processes (a) through (d) for all unit cells of the MRAM cell array.

17. The use of claim 16, wherein the target unit cell 19 is selected using a previously inputted address information of the MRAM cell array by a cell addressing unit (13,14).

18. The use of claim 17, wherein in the applying of the magnetic field, a source measurement unit (15) applies an electric potential to the selected unit cell, thereby forming an internal magnetic field.

19. The use of claim 17 or 18, wherein the resistance of the selected unit cell is measured using data that is obtained by a probe of a probe card (13), the probe card (13) being positioned at a data storage portion of the selected unit cell.

## Patentansprüche

1. Analysegerät für einen magnetischen Direktzugriffspeicher, kurz MRAM, umfassend:
eine MRAM-Montageeinheit (11), auf der ein MRAM angebracht ist,
eine Magnetfeldanlegeeinheit (12, 17), die um die MRAM-Montageeinheit positioniert ist und ein externes Magnetfeld an den auf der MRAM-Montageeinheit angebrachten MRAM anlegt,
eine Zelladressiereinheit (13, 14), die eine Zelleinheit des auf der MRAM-Montageeinheit angebrachten MRAM bestimmt,
eine Quellenmesseinheit (15), die ein internes Magnetfeld an die Zelleinheit des MRAM anlegt oder einen Widerstand der Zelleinheit des MRAM misst, und
eine Computereinheit (16), die Daten bezüglich des gemessenen Widerstands jeder Zelleinheit des MRAM speichert und analysiert.

2. Analysegerät nach Anspruch 1, wobei die Magnetfeldanlegeeinheit (12, 17) umfasst:
eine Energieversorgungseinheit (17), die Energie zuführt, und
einen Magnetfeldgenerator (12), der ein Magnetfeld erzeugt, das an den MRAM angelegt wird, der auf der MRAM-Montageeinheit angebracht ist.

3. Analysegerät nach Anspruch 2, wobei der Magnetfeldgenerator (12) eine Helmholtz-Spule ist, die in Form einer gedrehten Ringspule ausgebildet ist.

4. Analysegerät nach einem der vorhergehenden Ansprüche, wobei die Zelladressiereinheit (13, 14) umfasst:
einen Matrixschalter (14), der die Zelleinheit des auf der MRAM-Montageeinheit angebrachten MRAM bestimmt, und
eine Messkarte (13), die an einer Position angebracht ist, die dem MRAM entspricht, wobei die Messkarte der Zelleinheit Energie zuführt oder Daten aus der Zelleinheit ausliest.

5. Analysegerät nach einem der vorhergehenden Ansprüche, ferner umfassend eine Magnetfeldmesseinheit (18), die das externe Magnetfeld misst, das durch die Magnetfeldanlegeeinheit an den MRAM angelegt wird.

6. Verwendung eines Analysegeräts nach einem der Ansprüche 1 bis 5 zum Ausführen eines Analysenverfahrens für MRAM, umfassend:
(a) Anlegen eines Magnetfelds an eine MRAM-Zellanordnung (20),
(b) Auswählen einer Zielzelleinheit (19) aus der MRAM-Zellanordnung,
(c) Messen eines Widerstands der ausgewählten Zelleinheit (19) und Speichern des gemessenen Widerstands,
und Wiederholen der Schritte (b) und (c) und Verändern der Stärke eines Magnetfelds zum Messen der Widerstände der Zelleinheiten entsprechend der veränderten Stärke des Magnetfelds.

7. Verwendung nach Anspruch 6, umfassend:
(d) Verändern der Stärke eines an die ausgewählte Zelleinheit (19) angelegten Magnetfelds und Messen der Widerstände der ausgewählten Zelleinheit entsprechend der veränderten Stärke des Magnetfelds und
(e) Durchführen der Prozesse (b) bis (d) für ganze Zelleinheiten (19), die die MRAM-Zellanordnung bilden.

8. Verwendung nach Anspruch 6, umfassend:
(d) nach Messen des Widerstands der ausgewählten Zelleinheit, Durchführen der Prozesse (b) und (c) für die übrigen Zelleinheiten (19), die die MRAM-Zellanordnung (20) bilden, und
(e) Verändern der Stärke des Magnetfelds und Durchführen der Prozesse (a) bis (d) für alle Zelleinheiten der MRAM-Zellanordnung.

9. Verwendung nach Anspruch 7 oder 8, wobei das Magnetfeld durch eine Helmholtz-Spule (12) angelegt wird, die in Form einer gedrehten Ringspule ausgebildet ist.

10. Verwendung nach Anspruch 7, 8 oder 9, wobei die Zielzelleinheit (19) unter Verwendung einer zuvor eingegebenen Adressinformation der MRAM-Zelleinheit durch eine Zelladressiereinheit ausgewählt wird.

11. Verwendung nach Anspruch 7, 8, 9 oder 10, wobei der Widerstand der ausgewählten Zelleinheit (19) unter Verwendung von Daten gemessen wird, die von einem Messfühler einer Messkarte (13) ermittelt sind, wobei die Messkarte (13) an einem Datenspeicherabschnitt der ausgewählten Zelleinheit positioniert ist.

12. Verwendung nach Anspruch 6, umfassend:
(d) nach Messen des Widerstands der ausgewählten Zelleinheit (19), Verändern der Stärke eines an die ausgewählte Zelleinheit angelegten Magnetfelds und Messen der Widerstände der ausgewählten Zelleinheit entsprechend der veränderten Stärke des Magnetfelds und
(e) Durchführen der Prozesse (a) bis (d) für ganze Zelleinheiten, die die MRAM-Zellanordnung bilden.

13. Verwendung nach Anspruch 12, wobei die Zielzelleinheit (19) unter Verwendung einer zuvor eingegebenen Adressinformation der MRAM-Zelleinheit durch eine Zelladressiereinheit (13, 14) ausgewählt wird.

14. Verwendung nach Anspruch 12 oder 13, wobei beim Anlegen des Magnetfelds eine Quellenmesseinheit (15) ein elektrisches Potential an die ausgewählte Zelleinheit anlegt, wodurch ein internes Magnetfeld ausgebildet wird.

15. Verwendung von MRAM nach Anspruch 12, 13 oder 14, wobei der Widerstand der ausgewählten Zelleinheit (19) unter Verwendung von Daten gemessen wird, die von einem Messfühler einer Messkarte (13) ermittelt werden, wobei die Messkarte an einem Datenspeicherabschnitt der ausgewählten Zelleinheit positioniert ist.

16. Verwendung nach Anspruch 6, umfassend:
(c) Messen des Widerstands der ausgewählten Zelleinheit (19) und Speichern des gemessenen Widerstands,
(d) danach Durchführen der Prozesse (a) bis (c) für die übrigen Zelleinheiten, die die MRAM-Zellanordnung (20) bilden, und
(e) Verändern der Stärke eines Magnetfelds und Durchführen der Prozesse (a) bis (d) für alle Zelleinheiten der MRAM-Zellanordnung.

17. Verwendung nach Anspruch 16, wobei die Zielzelleinheit 19 unter Verwendung einer zuvor eingegebenen Adressinformation der MRAM-Zelleinheit durch eine Zelladressiereinheit (13, 14) ausgewählt wird.

18. Verwendung nach Anspruch 17, wobei beim Anlegen des Magnetfelds eine Quellenmesseinheit (15) ein elektrisches Potential an die ausgewählte Zelleinheit anlegt, wodurch ein internes Magnetfeld ausgebildet wird.

19. Verwendung nach Anspruch 17 oder 18, wobei der Widerstand der ausgewählten Zelleinheit unter Verwendung von Daten gemessen wird, die von einem Messfühler einer Messkarte (13) ermittelt werden, wobei die Messkarte an einem Datenspeicherabschnitt der ausgewählten Zelleinheit positioniert ist.

## Revendications

1. Appareil d'analyse d'une mémoire vive magnétique, abrégée par MRAM, comprenant :
une unité de montage de MRAM (11) sur laquelle est montée une MRAM ;
une unité d'application de champ magnétique (12, 17) qui est positionnée autour de l'unité de montage de MRAM et applique un champ magnétique externe à la MRAM montée sur l'unité de montage de MRAM ;
une unité d'adressage de cellule (13, 14) qui désigne une cellule unitaire de la MRAM montée sur l'unité de montage de MRAM ;
une unité de mesure de source (15) qui applique un champ magnétique interne à la cellule unitaire de la MRAM ou mesure une résistance de la cellule unitaire de la MRAM ; et
une unité d'ordinateur (16) qui stocke et analyse des données concernant la résistance mesurée de chaque cellule unitaire de la MRAM.

2. Appareil d'analyse selon la revendication 1, dans lequel l'unité d'application de champ magnétique (12, 17) comprend :
une unité d'alimentation (17) qui alimente ; et
un générateur de champ magnétique (12) qui génère un champ magnétique appliqué à la MRAM qui est montée sur l'unité de montage de MRAM.

3. Appareil d'analyse selon la revendication 2, dans lequel le générateur de champ magnétique (12) est une bobine de Helmholtz qui a la forme d'une bobine circulaire tournée.

4. Appareil d'analyse selon l'une quelconque des revendications précédentes, dans lequel l'unité d'adressage de cellule (13, 14) comprend :
un commutateur de matrice (14) qui désigne la cellule unitaire de la MRAM montée sur l'unité de montage de MRAM- ; et
une carte de contrôle (13) qui est montée sur une position correspondant à la MRAM, la carte de contrôle alimentant la cellule unitaire ou lisant des données de la cellule unitaire.

5. Appareil d'analyse selon l'une quelconque des revendications précédentes, comprenant en outre une unité de mesure de champ magnétique (18), qui mesure le champ magnétique externe qui est appliqué à la MRAM par l'unité d'application de champ magnétique.

6. Utilisation d'un appareil d'analyse selon l'une quelconque des revendications 1 à 5 pour réaliser un procédé d'analyse de MRAM, comprenant :
(a) l'application d'un champ magnétique à un groupe de cellules de MRAM (20) ;
(b) la sélection d'une cellule unitaire cible (19) parmi le groupe de cellules de MRAM ;
(c) la mesure d'une résistance de la cellule unitaire sélectionnée (19) et le stockage de la résistance mesurée ;
et la répétition des étapes (b) et (c) et la variation d'une force du champ magnétique pour mesurer les résistances des cellules unitaires selon la force variée du champ magnétique.

7. Utilisation selon la revendication 6, comprenant :
(d) la variation d'une force du champ magnétique appliqué à la cellule unitaire sélectionnée (19) et la mesure des résistances de la cellule unitaire sélectionnée selon la force variée du champ magnétique ; et
(e) l'exécution des processus (b) à (d) pour l'ensemble des cellules unitaires (19) qui constituent le groupe de cellules de MRAM.

8. Utilisation selon la revendication 6, comprenant :
(d) après la mesure de la résistance de la cellule unitaire sélectionnée, l'exécution des processus (b) et (c) pour les autres cellules unitaires (19) qui constituent le groupe de cellules de MRAM (20) ; et
(e) la variation d'une force du champ magnétique et l'exécution des processus (a) à (d) pour toutes les cellules unitaires du groupe de cellules de MRAM.

9. Utilisation selon la revendication 7 ou 8, dans laquelle le champ magnétique est appliqué par une bobine de Helmholtz (12) qui a la forme d'une bobine circulaire tournée.

10. Utilisation selon les revendications 7, 8 ou 9, dans laquelle la cellule unitaire cible (19) est sélectionnée en utilisant une information d'adresse précédemment entrée du groupe de cellules de MRAM par une unité d'adressage de cellule.

11. Utilisation selon les revendications 7, 8, 9 ou 10, dans laquelle la résistance de la cellule unitaire sélectionnée (19) est mesurée en utilisant des données qui sont obtenues par une sonde d'une carte de contrôle (13), la carte de contrôle (13) étant positionnée au niveau d'une partie de stockage de données de la cellule unitaire sélectionnée.

12. Utilisation selon la revendication 6, comprenant :
(d) après la mesure de la résistance de la cellule unitaire sélectionnée (19), la variation d'une force du champ magnétique appliqué à la cellule unitaire sélectionnée et la mesure des résistances de la cellule unitaire sélectionnée selon la force variée du champ magnétique ; et
(e) l'exécution des processus (a) à (d) pour l'ensemble des cellules unitaires qui constituent le groupe de cellules de MRAM.

13. Utilisation selon la revendication 12, dans laquelle la cellule unitaire cible (19) est sélectionnée en utilisant une information d'adresse précédemment entrée du groupe de cellules de MRAM par une unité d'adressage de cellule (13, 14).

14. Utilisation selon la revendication 12 ou 13, dans laquelle, dans l'application du champ magnétique, une unité de mesure de source (15) applique un potentiel électrique à la cellule unitaire sélectionnée, formant ainsi un champ magnétique interne.

15. Utilisation d'une MRAM selon les revendications 12, 13 ou 14, dans laquelle la résistance de la cellule unitaire sélectionnée (19) est mesurée en utilisant des données qui sont obtenues par une sonde d'une carte de contrôle (13), la carte de contrôle étant positionnée au niveau d'une partie de stockage de données de la cellule unitaire sélectionnée.

16. Utilisation selon la revendication 6, comprenant :
(c) la mesure de la résistance de la cellule unitaire sélectionnée (19) et le stockage de la résistance mesurée ;
(d) après l'exécution des processus (a) à (c) pour les autres cellules unitaires qui constituent le groupe de cellules de MRAM (20) ; et
(e) la variation d'une force du champ magnétique et l'exécution des processus (a) à (d) pour toutes les cellules unitaires du groupe de cellules de MRAM.

17. Utilisation selon la revendication 16, dans laquelle la cellule unitaire cible (19) est sélectionnée en utilisant une information d'adresse précédemment entrée du groupe de cellules de MRAM par une unité d'adressage de cellule (13, 14).

18. Utilisation selon la revendication 17, dans laquelle, dans l'application du champ magnétique, une unité de mesure de source (15) applique un potentiel électrique à la cellule unitaire sélectionnée, formant ainsi un champ magnétique interne.

19. Utilisation selon la revendication 17 ou 18, dans laquelle la résistance de la cellule unitaire sélectionnée est mesurée en utilisant des données qui sont obtenues par une sonde d'une carte de contrôle (13), la carte de contrôle (13) étant positionnée au niveau d'une partie de stockage de données de la cellule unitaire sélectionnée.
